# EUROPÄISCHE PATENTANMELDUNG

(11) **EP 2 293 340 A2**
(43) Veröffentlichungstag der Anmeldung: **09.03.2011**
(21) Anmeldenummer: 10008396.3
(22) Anmeldetag: 11.08.2010
(51) Int. Cl.: H01L 31/0224, H01L 31/0236, H01L 31/0392, H01L 31/052, H01L 31/18, C23C 14/08

(54) **Dünnschichtsolarmodul und Verfahren zu dessen Herstellung**

(30) Priorität: 08.09.2009 DE 102009040621
(71) Anmelder: Schott Solar AG, 55122 Mainz (DE)
(72) Erfinder: Berginski, Michael, Dr., 85640 Putzbrunn (DE); Lechner, Peter, 85591 Vaterstetten (DE)
(74) Vertreter: von Puttkamer · Berngruber

(57) **Zusammenfassung**

Bei einem Dünnschichtsolarmodul, das ein transparentes Substrat (1), eine auf dem Substrat (1) abgeschiedene transparente Frontelektrodenschicht (2) aus dotiertem Zinkoxid, eine Halbleiterschicht (3), ggf. eine auf der Halbleiterschicht (3) abgeschiedene Rückelektrodenschicht (4) aus dotiertem Zinkoxid und eine reflektierende Schicht (5) auf der der Lichteinfallseite (hv) abgewandten Rückseite aufweist, nimmt die Dotiermenge in der dotierten Zinkoxid-Frontelektrodenschicht (2) von dem Substrat (1) zu der Halbleiterschicht (3) hin und/oder die Dotiermenge in der dotierten Zinkoxid-Rückelektrodenschicht (4) von der Halbleiterschicht (3) zu der reflektierenden Schicht (5) hin ab.

## Beschreibung

Die Erfindung bezieht sich auf ein Dünnschichtsolarmodul nach dem Oberbegriff des Anspruchs 1 und ein Verfahren zu dessen Herstellung.

Dünnschichtsolarmodule bestehen im Wesentlichen aus einem transparenten, elektrisch nicht leitfähigen Substrat, insbesondere Glas, einer transparenten, leitfähigen Frontelektrodenschicht, einer Halbleiterschicht und einer reflektierenden Schicht aus z.B. einem ein- oder mehrschichtigen Metallsystem oder aus einem weißen Dielektrikum auf der Rückseite.

Die Frontelektrodenschicht besteht im Allgemeinen aus dotiertem Zinnoxid oder aus z.B. mit Bor, Gallium oder Aluminium dotiertem Zinkoxid.

Die Deposition der Frontelektrodenschicht auf dem Substrat erfolgt meist durch Sputtern. Dazu werden z.B. mit Aluminiumoxid (Al₂O₃) dotierte keramische Zinkoxid (ZnO)-Sputter-Targets mit einem bestimmten Al₂O₃-Gehalt von z.B. 1 Gew.-% oder 2.-% verwendet. Alternativ wird reaktiv von metallischen Zink-Aluminium Targets gesputtert. Das Sputtergas besteht in beiden Fällen aus einem Edelgas sowie insbesondere im Falle des reaktiven Sputterns aus Sauerstoff.

Während Targets mit einem hohen Al₂O₃-Gehalt von 2 Gew.-% den Nachteil aufweisen, dass die resultierende Schicht eine hohe Lichtabsorption besitzt, haben Targets mit einem geringen Al₂O₃-Gehalt von 1 Gew.-% den Nachteil, dass für den gewünschten Flächenwiderstand der deponierten Schicht dicke Schichten meist mit mehr als 1000 nm gesputtert werden müssen.

Ein weiterer Nachteil besteht darin, dass bei einem dotieren ZnO-Sputter-Target mit einem geringen Al₂O₃-Gehalt von 1 Gew.-% das Substrat beim Sputtern auf eine hohe Temperatur von mehr als 250 °C erhitzt werden muss, was ein aufwändiges Maschinendesign, lange Aufheiz- und Abkühlstrecken und hohe Betriebskosten zur Folge hat.

Wenn als reflektierende Schicht auf der Rückseite des Moduls ein weißes Dielektrikum, also beispielsweise weiße Farbe oder eine weiße Folie, verwendet wird, die nicht elektrisch leitfähig ist, wird zwischen der Halbleiterschicht und der weißen reflektierenden Schicht als Rückelektrodenschicht ebenfalls eine dotierte Zinkoxid- oder Zinnoxidschicht mit einer relativ großen Schichtdicke von beispielsweise 200 nm bis 3000 nm gesputtert.

Aufgabe der Erfindung ist es, mit möglichst geringem Energie- und Maschinenaufwand eine hochqualitative Frontelektrodenschicht und, falls die reflektierende Schicht aus einer weißen Materialschicht besteht, zugleich eine hochqualitative Rückelektrodenschicht herzustellen.

Dies wird erfindungsgemäß dadurch erreicht, dass die Dotiermenge der dotierten ZnO-Frontelektrodenschicht vom Substrat zur Halbleiterschicht hin abnimmt. Falls das Dünnschichtsolarmodul eine weiße reflektierende dielektrische Materialschicht und damit eine dotierte Zinkoxid-Rückelektrodenschicht aufweist, kann die Dotiermenge in der dotierten ZnO-Rückelektrodenschicht von der Halbleiterschicht zu der reflektierenden weißen Materialschicht erfindungsgemäß ebenfalls abnehmen.

Die Abnahme von einer zur anderen Seite der Frontelektrodenschicht oder der Rückelektrodenschicht kann erfindungsgemäß kontinuierlich oder in Stufen erfolgen.

Vorzugsweise beträgt erfindungsgemaß die Dotiermenge, also die Anzahl der Dotier-Fremdatome in dem Zinkoxid, an der dem Substrat zugewandten Seite der ZnO-Frontelektrodenschicht und/oder die Dotiermenge an der der Halbleiterschicht zugewandten Seite der ZnO-Rückelektrodenschicht höchstens 2x10²¹ cm⁻³ und an der der Halbleiterschicht zugewandten Seite der ZnO-Frontelektrodenschicht und/oder an der reflektierenden weißen Materialschicht zugewandten Seite der ZnO-Rückelektrodenschicht unter 1x20²¹ cm⁻³, vorzugsweise zwischen 4x10²⁰ cm⁻³ und 8x10²⁰ cm⁻³_{.}

Das Zinkoxid wird vorzugsweise mit Aluminium, Gallium oder Bor dotiert. Desweiteren können Indium, Germanium, Silizium und Fluor eingesetzt werden. Während die Aluminium- oder Gallium-dotierte ZnO-Schicht vorzugsweise durch Sputtern mit ZnO- Al₂O₃- oder ZnO-Ga₂O₃-Targets mit unterschiedlicher Al₂O₃- bzw. Ga₂O₃-Konzentration gebildet wird, wird die mit Bor dotierte ZnO-Schicht vorzugsweise durch chemische Dampfphasenabscheidung bei niedrigem Druck oder LPCVD ("Low Pressure Chemical Vapor Deposition") erhalten. Dabei kann als gasförmige Borverbindung beispielsweise Diboran oder Trimethylbor verwendet werden, wobei zu Beginn der Abscheidung der ZnO-Schicht eine entsprechend größere Menge der Bor-Verbindung zugegeben wird als gegen Ende der Abscheidung.

Der Zusammenhang zwischen der Target-Dotierstoffmenge und der resultierenden Dotiermenge in der Elektrodenschicht wurde für keramische mit Al2O3 dotierte ZnO Targets von z.B. Agashe et al. (Journal of Applied Physics, 95, 2004, S. 1911-1917) untersucht. Die Autoren fanden neben einem linearen Zusammenhang zwischen Target-Dotierstoffmenge und Elektroden-Dotiermenge zum Beispiel, dass eine Target-Dotierstoffmenge von 1,0 Gew. % zu Elektrodenschichten mit einer Dotiermenge von ca. 7x10²⁰ cm⁻³ führt,

Die dotierte ZnO-Frontelektrodenschicht und/oder die dotierte ZnO-Rückelektrodenschicht weist vorzugsweise einen Flächenwiderstand von weniger als 24 Ohm/square, insbesondere weniger als 18 Ohm/square, besonders bevorzugt weniger als 14 Ohm/square auf.

Die Lichtabsorption der dotierten ZnO-Frontelektrodenschicht oder - Rückelektrodenschicht beträgt bei einer Lichtwellenlänge von 700 nm vorzugsweise weniger als 5 %, insbesondere weniger als 4 % und besonders bevorzugt weniger als 3,5 % und bei einer Lichtwellenlänge von 950 nm vorzugsweise weniger als 8 %, insbesondere weniger als 7%, besonders bevorzugt weniger als 6 % des einfallenden Lichts.

Das Substrat des erfindungsgemäßen Dünnschichtsolarmoduls besteht üblicherweise aus einer Glasscheibe. Die Halbleiterschicht besteht vorzugsweise aus Silizium. Sie ist vorzugsweise aus Teilschichten aufgebaut, beispielsweise aus mikrokristallinen oder amorphen Siliziumteilschichten. Die Halbleiterschicht kann jedoch auch aus einem Verbundhalbleiter bestehen, beispielsweise einem II-VI Halbleiter wie Cadmium-Tellurid, einem III-V-Halbleiter wie Gallium-Arsenid oder einem I-III-VI-Halbleiter wie Kupfer-Indium-Diselenid.

Die dotierte ZnO-Rückelektrodenschicht weist vorzugsweise eine Schichtdicke von mindestens 300 nm, insbesondere mindestens 400 nm, also beispielsweise etwa 500 nm auf.

Für die ZnO-Frontelektrodenschicht wird zunächst eine dicke Schicht mit einer Dicke von vorzugsweise 500 bis 5000 nm, insbesondere 1000 bis 2000 nm abgeschieden, die dann einer Ätzbehandlung unterworfen wird.

An der der Halbleiterschicht zugewandten Seite wird die abgeschiedene Frontelektrodenschicht nämlich mit einer bestimmten Oberflächentopographie oder Rauigkeit versehen, um ihr "Lighttrapping"-Eigenschaften zu verleihen, d.h. das Licht, das durch die Halbleiterschicht in Richtung Substrat zurückreflektiert wird, soll möglichst vollständig wieder zurück in die Halbleiterschicht reflektiert werden. Dazu wird die auf dem Substrat abgeschiedene, dicke dotierte ZnO-Halbleiterschicht geätzt, beispielsweise mit einer Säure, z.B, verdünnter Salzsäure. In der Frontelektrodenschicht werden dadurch auf der der Halbleiterschicht zugewandten Seite kraterförmige Vertiefungen mit einer Tiefe von vorzugsweise 50 bis 600 nm, insbesondere 150 bis 400 nm, einer Breite von vorzugsweise 500 bis 5000 nm, insbesondere 800 bis 3000 nm und einem Öffnungswinkel von vorzugsweise 100 bis 150 °, vorzugsweise 110 bis 145 ° gebildet. Die mittlere oder RMS (Root Mean Square)-Rauigkeit beträgt nach dem Ätzen vorzugsweise mindestens 50 nm, insbesondere mindestens 100 nm. Durch das Ätzen dieser Strukturen wird die Schichtdicke der Frontelektrodenschicht auf vorzugsweise mindestens 20 nm, insbesondere 50 bis 300 nm, an den dünnsten Stellen der kraterförmigen Vertiefungen reduziert. Nur an vereinzelten Stellen kann die Frontelektrode bis auf das Substrat weg geätzt sein.

Zum Sputtern der dotierten ZnO-Frontelektrodenschicht und/oder -Rückelektrodenschicht wird eine Sputter-Anlage verwendet. Dabei können für das Sputtern der Frontelektrodenschicht und der Rückelektrodenschicht getrennte Sputter-Anlagen zum Einsatz kommen.

Die bzw. jede Sputter-Anlage weist eine Schleuse zum Einschleusen des Substrats, also normalerweise der Glasscheibe, und mehrere nacheinander angeordnete ZnO-Sputter-Stationen mit jeweils einem Sputter-Target aus dotiertem ZnO auf, ferner ggf. eine oder mehrere Aufheizstrecken. Zudem kann beispielsweise eine Sputter-Station für eine Barriereschicht zwischen dem Glassubstrat und der dotierten ZnO-Frontelektrode zwischen der Einlassschleuse und den ZnO-Sputter-Stationen vorgesehen sein, mit der beispielsweise neben einer Brechungsindexanpassung zur Reflexionsminimierung eine Diffusion von z.B. Natrium-Ionen aus dem Glassubstrat in die ZnO-Schicht verhindert wird. Dazu kann z.B. ein Sputter-Target aus Siliziumdioxid (SiO₂) oder Siliziumoxinitrid (SiOxNy) mit x >0,1 und x + y = 1,5 verwendet werden.

Die Substrate fahren typischerweise an ca. 5 bis ca. 10 ZnO-Sputter-Stationen entlang, um eine dotierte ZnO-Schicht mit einer Gesamtdicke von beispielsweise 1000 nm sukzessive abzuscheiden.

Zur Abscheidung der ZnO-Frontelektrodenschicht werden vorzugsweise Doppel-Rohrkathoden mit keramischen ZnO:Al₂O₃- oder ZnO:-Ga₂O₃-Targets verwendet, von denen gepulst DC-gesputtert wird.

Dabei weist das ZnO-Sputter-Target der dem Einschleusebereich benachbarten Sputter-Station der Depositionsanlage zum Sputtern der Frontelektrodenschicht eine Dotierstoffmenge, d.h. einen Gehalt an dem Fremdoxid Al₂O₃ oder Ga₂O₃ von vorzugsweise zwischen 0,9 und 3,1 Gew.-%, insbesondere zwischen 1,1 und 2,5 Gew.-%, besonders bevorzugt zwischen 1,5 und 2,1 Gew.-% auf, wobei die Dotierstoffmenge der ZnO-Sputter-Targets zum Ausschleusebereich der Sputter-Anlage abnimmt, und zwar bis zu einer Target-Dotierstoffmenge zwischen vorzugsweise 0,2 und 1,5 Gew.-%, insbesondere zwischen 0,5 und 1,2 Gew.-%, besonders bevorzugt zwischen 0,7 und 1 Gew.-%. Analog weist das ZnO-Sputter-Target in der dem Einschleusebereich benachbarten Sputter-Station der Sputter-Anlage zum Sputtern der Rückelektrodenschicht eine Dotierstoffmenge vorzugsweise zwischen 0,9 und 3,1 Gew.-%, insbesondere zwischen 1,1 und 2,5 Gew.-%, besonders bevorzugt zwischen 1,5 und 2,1 Gew.-% auf, wobei die Dotierstoffmenge der ZnO-Sputter-Targets zum Ausschleusebereich auf vorzugsweise 0,2 bis 1,5 Gew.-%, inebsondere 0,5 bis 1,2 Gew.-%, besonders bevorzugt 0,7 bis 1,2 Gew.-% abnimmt.

Dies bezieht sich auf den maßgeblichen Teil der deponierten ZnO-Frontelektrode bzw. -Rückelektrode. Z,B. eventuell zusätzlich vorhandene, einzelne oder wenige Sputter-Stationen ganz zu Beginn der Sputter-Strecke beispielsweise eine 2 bis 5 nm dicke ZnO-Saatschicht oder eine beispielsweise zur Brechungsindex-Anpassung zum Ende der ZnO-Frontelektroden-Deposition vorgesehene Schicht ist dabei nicht berücksichtigt.

Beispielsweise kann eine Target-Dotierstoffmenge-Variation für die Frontelektrodenschicht wie folgt erfolgen:
Am Start ein ZnO-Target mit 2 Gew.-% Al₂O₃ mit nachfolgender Herabsetzung der Al₂O₃-Menge in einem Zwischenbereich auf 1 Gew.-% hin bis zu abschließend 0,5 Gew.-% Al₂O₃ nahe dem Ausschleusebereich.

Die Temperatur des Substrats beim Sputtern der ZnO-Frontelektrodenschicht kann vorzugsweise höchstens 280 °C in der dem Ausschleusebereich benachbarten Sputterstation betragen. So kann bei dem vorstehenden Beispiel mit einem Al₂O₃-dotierten ZnO-Target die notwendige Substrattemperatur von beispielsweise etwa 80 °C an der dem Einschleusebereich benachbarten Sputter-Station auf etwa 250 °C an der Sputter-Station, die dem Ausschleusebereich benachbart ist, ansteigen.

Demgegenüber wird beim Sputtern der dotierten ZnO-Rückkontaktschicht das Substrat vorzugsweise auf höchstens 180 °C erwärmt, da oberhalb dieser Temperatur eine Schädigung der Halbleiterschicht erfolgen kann.

Durch die Erfindung werden unter anderem folgende Vorteile realisiert.

Da höher dotierte, beispielsweise zwischen 0,9 und 3 Gew.-% mit Al₂O₃-dotierte ZnO-Targets bereits bei vergleichsweise niedrigen Substrat-Temperaturen die gewünschten Schichteigenschaften ermöglichen, kann der Teil der Sputter-Anlage, der dem Einschleusebereich benachbart ist, auf niedrige Prozesstemperaturen ausgelegt werden, insbesondere auf eine Temperatur unterhalb 200 °C, wodurch preiswertere Materialien eingesetzt und die Investitionskosten der Sputter-Anlage reduziert werden.

Durch die Verwendung der vergleichsweise hoch dotierten Targets zu Beginn der Sputterstrecke und den damit verbundenen niederen Prozesstemperaturen, typischerweise unterhalb von 200 °C, kann die Aufheizstrecke verkürzt werden, was sich hinsichtlich der Investitionskosten zusätzlich positiv auswirkt.

Das Substrat wird durch den Sputter-Prozess zusätzlich aufgeheizt. Durch Heizeinrichtungen, die an den Sputter-Stationen der Sputter-Anlage vorgesehen sein können, kann eine weitere kontrollierte Aufheizung der Substrate erfolgen, sodass an dem Ende der Sputter-Strecke mit ZnO-Sputter-Targets mit einem hohem Gehalt an Fremdoxid die Substrat-Temperatur erhöht ist. Da, wie festgestellt wurde, bei einem hohen Gehalt der Sputter-Targets an Fremdoxid die Substrat-Temperatur in einem weiten Bereich schwanken kann, ohne die Eigenschaften der dotierten ZnO-Schicht zu beeinträchtigen, können die ansonsten in der Sputter-Anlage räumlich getrennt erfolgenden Aufgaben Aufheizen und Sputtern in diesem Teil der Anlage zusammengefasst werden, womit zugleich die Heizleistung des Sputter-Prozesses ausgenutzt wird.

Trotz Reduktion der Target-Dotierstoffmenge entlang der Sputterstrecke kann in einer bevorzugten Ausführungsform das Sputtergas oder Sputtergasgemisch in sämlichen Zinkoxid-Sputterstationen identisch gewählt werden. Diese Ausführungsform ist bevorzugt, da in diesem Fall keine Gas-Trennung zwischen mehreren Sputterstationen erforderlich ist.

Das am Anfang der Sputter-Strecke von hochdotierten Targets abgeschiedene Material besitzt eine vergleichsweise hohe Ladungsträgerdichte von häufig deutlich mehr als 2 x 10²⁰ cm⁻³, wodurch der geforderte niedrige Flächenwiderstand ermöglicht wird. Würde hingegen die gesamte beispielsweise 1000 nm dicke dotierte ZnO-Schicht aus diesem Material aufgebaut sein, so ließe sich nicht gleichzeitig eine möglichst niedrige Lichtabsorption realisieren und desweiteren hätte die Oberflächentopographie nach dem Ätzen einen unerwünscht hohen Anteil an zu kleinen Kratern. Durch die Reduktion der Target-Dotierstoffmenge entlang der Sputter-Strecke werden damit drei, teilweise widerstrebende Schichtanforderungen voneinander entkoppelt. Der hochdotierte Schichtbestandteil der dotierten ZnO-Frontelektrodenschicht, der dem Substrat des Moduls benachbart ist, liefert den geforderten niedrigen Flächenwiderstand, während die am Ende der Sputter-Strecke von den Targets mit der niedrigen Dotierstoffmenge deponierten Schichtbestandteile durch ihre hohe Transparenz die insgesamt geforderte möglichst niedrige Lichtabsorption ermöglichen. Beim Rückätzen wird vorwiegend das niedrig dotierte Material abgetragen, wodurch eine günstigere Oberflächentopographie als mit einem höher dotierten Material beim Ätzen erhalten wird.

Beim Lighttrapping in der Dünnschichtsolarzelle durchläuft das insbesondere langwellige Licht eine Vielzahl von Durchgängen durch die Halbleiterschicht, bei einer Halbleiterschicht aus Silizium, beispielsweise ca. 5 bis 20 Durchläufe. Zwar erfolgt die Mehrzahl der Durchläufe in der Halbleiterschicht, da sie den höchsten Brechungsindex aufweist, trotzdem reicht die Photonen-Aufenthaltswahrscheinlichkeit auch in die direkt an die Halbleiterschicht angrenzenden Bereiche des Moduls mit hinein, sodass sich die Grenzfläche zwischen der Halbleiterschicht und den an sie angrenzenden Bereichen nachteilig auf das Lighttrapping auswirken kann. Durch die erfindungsgemäße graduelle Abnahme der Dotiermenge in der Frontelektrodenschicht wird damit auch die Lichtabsorption durch die Frontelektrodenschicht graduell verringert. Insbesondere in dem halbleiternahen Bereich der Frontelektrodenschicht befinden sich weniger freie Ladungsträger und Dotieratome, welche Photonen absorbieren können.

Trotz hoher Prozess-Kontrolle neigen gesputterte, dotierte ZnO-Schichten zu einer Schwankung der Ätzrate beim Nassätzen. Dies führt zu einer Schwankung der Schichtdicke und damit zu einer Schwankung des Flächenwiderstandes. Diese Schwankungen wirken sich auf die Modulkenndaten aus. Durch die erfindungsgemäß graduell abnehmende Target-Dotierstoffmenge trägt der dem Substrat zugewandte Schichtanteil der Frontelektrodenschicht den Schwerpunkt der elektrischen Anforderungen. Variationen in der Ätzgeschwindigkeit schlagen sich daher nur abgeschwächt auf Variationen des Flächenwiderstandes durch, sodass insgesamt weniger stark variierende Modulkenndaten resultieren.

Im Fall der dotierten ZnO-Rückelektrodenschicht zwischen der Halbleiterschicht und der weißen reflektierenden Schicht ist erfindungsgemäß vorgesehen, dass die Dotiermenge in der dotierten ZnO-Rückelektrodenschicht von der weißen reflektierenden Schicht zur Halbleiterschicht hin zunimmt, also von der Halbleiterschicht zur weißen reflektierenden Schicht abnimmt. Dadurch werden folgende Vorteile erreicht:
Es findet ein optisch günstiger Brechungsindex-Sprung zwischen Halbleiterschicht und Rückelektrodenschicht statt. ZnO-Schichten mit einer hohen Ladungsträgerdichte weisen tendenziell einen niedrigeren Brechungsindex auf. Da der Brechungsindex hier gegenüber dem Brechungsindex der Halbleiterschicht betrachtet werden muss, und dieser mit beispielsweise 3,5 bei einer Siliziumhalbleiterschicht höher liegt als der von Zinkoxid, findet die Reflexion an der Grenzfläche zwischen Halbleiterschicht und Rückelektrodenschicht um so ausgeprägter statt, umso niedriger der Brechungsindex der Rückelektrodenschicht ist. Ein großer Brechungsindex-Sprung an dieser Grenzfläche führt daher zu einer ausgeprägten Reflexion. Damit durchlaufen nur noch geringe Anteile des Lichts die Rückelektrodenschicht, um an der weißen, reflektierenden, dielektrischen Schicht reflektiert zu werden. Somit wird für diese bereits an dieser Grenzfläche zur Rückelektrodenschicht reflektierten Lichtanteile eine Lichtabsorption durch einen doppelten Durchgang durch die Rückelektrodenschicht bei Reflexion an der weißen Schicht nicht relevant.

Die Deposition der Rückelektrodenschicht ist wegen der ansonsten stattfindenden Schädigung der Halbleiterschicht oberhalb von etwa 180° Celsius hinsichtlich der Prozesstemperatur limitiert. Die Deposition erfolgt demnach möglichst bei einer Substrattemperatur von höchstens 180° Celsius, vorzugsweise höchstens 120° Celsius oder sogar bei Raumtemperatur. Bei diesen niedrigen Temperaturen lassen sich zwar hochdotierte ZnO-Schichten mit guten elektro-optischen Kennziffern, insbesondere einer hohen Beweglichkeit, deponieren, wohingegen die Qualität von niederdotierten ZnO-Schichten bei einer niedrigen Depositions-Temperatur schlechter ist. Folglich ist es vorteilhaft, die Deposition der Rückelektrodenschicht mit einem hochdotierten ZnO direkt auf der Halbleiterschicht zu beginnen.

In der weiteren Deposition sind zwei Faktoren für die abnehmende Dotiermenge zur weißen reflektierenden Schicht hin von Vorteil. Zum einen bietet die bereits gebildete, höher dotierte ZnO-Schicht eine gute Grundlage für ein qualitativ hochwertiges Wachstum der ZnO-Rückelektrodenschicht. Damit ist eine hohe elektro-optische Qualität des der Halbleiterschicht zugewandten Teils der Rückelektrodenschicht sichergestellt, die beispielsweise besser ist als die dem zum Beispiel aus Glas bestehenden Substrat zugewandten Teils der Frontelektrodenschicht.

Zudem hat sich wie vorstehend im Zusammenhang mit der Deposition der Frontelektrodenschicht beschrieben, das Substrat auch bei der Deposition der Rückelektrodenschicht während der Deposition des ersten, höher dotierten ZnO-Teils bereits aufgeheizt, so dass man sich automatisch in einen für eine niedrigdotierte ZnO-Schicht günstigeren Temperaturbereich bewegt.

Vergleicht man zwei Schichten gleicher Ladungsträgerzahl, gleicher Beweglichkeit aber unterschiedlicher Dicke und Ladungsträgerkonzentration, so absorbiert die höher dotierte und dünnere Schicht tendenziell mehr im langwelligen Spektralbereich und die nieder dotierte aber dickere Schicht vor allem im sichtbaren Spektralbereich. Auch aus diesem Zusammenhang ergibt sich, dass, wenn man bei vorgegebenem Flächenwiderstand einen Teil der Leitfähigkeit der Rückelektrodenschicht durch den niederdotierten, der weißen reflektierenden Schicht zugewandten Teil der ZnO-Schicht bereitstellen will, man einen Teil der Lichtabsorption aus dem langwelligen Spektralbereich in den sichtbaren Spektralbereich verlagert. Dies ist im Falle der Rückelektrodenschicht vorteilhaft, da durch die bereits erfolgte Lichtabsorption in der Halbleiterschicht die Reflexion an der weißen reflektierenden Schicht im langwelligen Spektralbereich erfolgt. Nachstehend ist die Erfindung anhand der beigefügten Zeichnung beispielhaft näher erläutert. Darin zeigen jeweils schematisch:
Figur 1 einen Schnitt durch einen Teil eines Dünnschichtsolarmoduls; und
Figur 2 eine Anlage zur Deposition der Frontelektrodenschicht des Dünnschichtsolarmoduls.

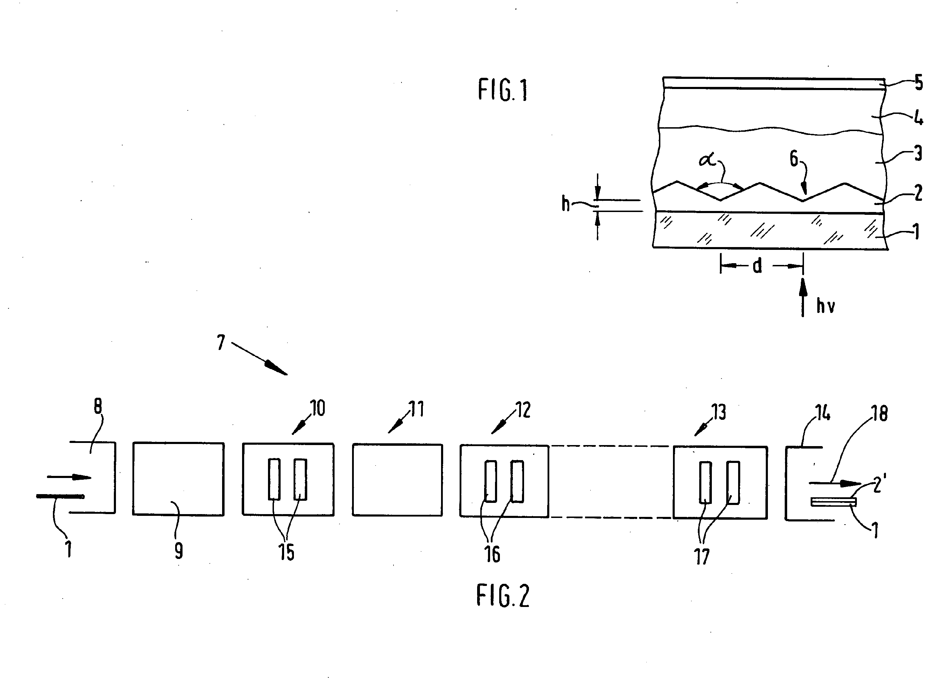

Gemäß Figur 1 besteht das Modul aus einem transparenten Substrat 1, beispielsweise einer Glasscheibe, einer transparenten Frontelektrodenschicht 2 aus z. B. mit Al dotiertem ZnO, einer Halbleiterschicht 3, z. B. aus Silizium, einer transparenten Rückelektrodenschicht 4 aus z. B. mit Al dotiertem ZnO und einer reflektierenden Schicht 5 z. B. aus einer weißen Farbe.

Die Dotiermenge in der dotierten ZnO-Frontelektrodenschicht 2 nimmt von dem Substrat 1 zu der Halbleiterschicht 3 hin ab, und die Dotiermenge in der dotierten ZnO-Rückelektrodenschicht 4 nimmt von der Halbleiterschicht 3 zur reflektierenden Schicht 5 ab, also von der reflektierenden Schicht 5 zur Halbleiterschicht 3 zu.

Die Frontelektrodenschicht 2 weist an ihrer der Halbleiterschicht zugewandten Seite eine durch einen Ätzprozess erzeugte Texturierung auf, die aus kraterförmigen Vertiefungen 6 besteht, welche eine Tiefe h von z. B. 150 bis 400 nm, einen durchschnittlichen Abstand d von z. B. 800 bis 3000 nm und einen Öffnungswinkel α von z. B. 110 bis 145 ° besitzen.

Gemäß Figur 2 besteht die Depositionsanlage 7 aus einem Einschleusebereich 8, über den das Substrat 1, beispielsweise eine Glasscheibe, in die Anlage 7 eingebracht wird, gefolgt von einem Evakuierbereich 9, an den Vakuumpumpen angeschlossen sind, einer ersten Sputterstation 10 mit einem Sputtertarget aus z. B. Siliziumoxinitrid zum Sputtern einer Barriereschicht auf die Glasschicht 1, einer Heizstrecke 11, die auch vor der Sputterstation 10 angeordnet sein kann, ferner mehreren Sputterstationen 12 und 13 zum Sputtern der z. B. mit Al₂O₃ dotierten ZnO-Frontelektrodenschicht auf das mit der Barriereschicht versehene Substrat 1 in einzelnen Teilschichten, wobei in der Zeichnung nur die dem Einschleusebereich 8 und dem Ausschleusebereich 14 benachbarten Sputterstationen 12 und 13 der Sputterstrecke zum Sputtern der dotierten ZnO-Frontelektrodenschicht dargestellt sind. Die Sputtertargets 15 bis 17 der Sputterstationen 15, 12 bis 13 können dabei aus zwei oder mehr Rohrkathoden bestehen.

Während das ZnO-Target 16 der Sputterstation 12, das dem Einschleusebereich 8 zugewandt ist, mit einer großen Menge an Al₂O₃ oder einem anderen Fremdoxid von beispielsweise 1,5 bis 2,1 Gew.% versehen ist, weist das ZnO-Target 17 der dem Ausschleusebereich 14 benachbarten Sputterstation 13 eine geringere Dotierstoffkonzentration von beispielsweise 0,7 bis 1,1 Gew.% Al₂O₃ oder einem anderen Fremdoxid auf.

Das gemäß dem Pfeil 18 aus der Dotieranlage 7 geschleuste, mit einer dicken dotierten ZnO-Schicht 2' versehene Substrat 1 wird anschließend beispielsweise mit verdünnter Salzsäure einer Ätzbehandlung unterworfen, um an der von dem Substrat 1 abgewandten Seite der ZnO-Schicht 2' die in Figur 1 dargestellten Vertiefungen 6 in der Frontelektrodenschicht 3 zu bilden. Die Ätzbehandlung und alle übrigen Schritte zur Herstellung des Dünnschichtsolarmoduls erfolgen ebenfalls in nicht dargestellten Durchlaufanlagen.

Im weiteren Verlauf wird die Halbleiterschicht 3 z. B. durch chemische Dampfabscheidung aufgetragen. Die Deposition der dotierten ZnO-Rückelektrodenschicht 4 kann dann in einer der Anlage entsprechenden Depositionsanlage 7 durchgeführt werden. Anschließend wird die weiße reflektierende Schicht 5 auf die Rückelektrodenschicht 4 aufgebracht.

## Patentansprüche

1. Dünnschichtsolarmodul, das ein transparentes Substrat (1), eine auf dem Substrat (1) abgeschiedene transparente Frontelektrodenschicht (2) aus dotiertem Zinkoxid, eine Halbleiterschicht (3), und/oder eine auf der Halbleiterschicht (3) abgeschiedene Rückelektrodenschicht (4) aus dotiertem Zinkoxid und eine reflektierende Schicht (5) auf der der Lichteinfallseite (hv) abgewandten Rückseite aufweist, **dadurch gekennzeichnet, dass** der Gehalt der Fremdatome in der dotierten Zinkoxid-Frontelektrodenschicht (2) von dem Substrat (1) zu der Halbleiterschicht (3) hin und/oder der Gehalt der Fremdatome in der dotierten Zinkoxid-Rückelektrodenschicht (4) von der Halbleiterschicht (3) zu der reflektierenden Schicht (5) hin abnimmt.

2. Dünnschichtsolarmodul nach Anspruch 1, **dadurch gekennzeichnet, dass** der Gehalt der Fremdatome in dem dotierten Zinkoxid an der dem Substrat (1) zugewandten Seite der Frontelektrodenschicht (2) und/oder der Gehalt der Fremdatome an der der Halbleiterschicht (3) zugewandten Seite der dotierten Rückelektrodenschicht (4) höchstens 2x10²¹ cm⁻³ und an der der Halbleiterschicht (3) zugewandten Seite der Frontelektrodenschicht (2) und/oder der der reflektierenden Schicht (5) zugewandten Seite der Rückelektrodenschicht (4) zwischen 1x10²⁰ cm⁻³ und 1x10²¹ cm⁻³ beträgt.

3. Dünnschichtsolarzelle nach Anspruch 1 oder 2, **dadurch gekennzeichnet, dass** das Fremdatom, mit dem das Zinkoxid dotiert ist, Aluminium, Gallium oder Bor ist.

4. Dünnschichtsolarzelle nach Anspruch 1, **dadurch gekennzeichnet, dass** die Frontelektrodenschicht (2) auf der der Halbleiterschicht (3) zugewandten Seite Vertiefungen (6) mit einer Tiefe von 50 bis 600 nm, einer Breite von 500 bis 5000 nm und einen Öffnungswinkel (α) von 100 bis 150 Grad aufweist.

5. Dünnschichtmodul nach einem der vorstehenden Ansprüche, **dadurch gekennzeichnet, dass** die Frontelektrodenschicht (2) auf der der Halbleiterschicht (3) zugewandten Seite eine RMS-Rauigkeit von mindestens 50 nm aufweist.

6. Dünnschichtsolarmodul nach einem der vorstehenden Ansprüche, **dadurch gekennzeichnet, dass** die Frontelektrodenschicht (3) und/oder die Rückelektrodenschicht (4) einen Flächenwiderstand von weniger als 24 Ω/square aufweist

7. Dünnschichtsolarmodul nach einem der vorstehenden Ansprüche, **dadurch gekennzeichnet, dass** die Frontelektrodenschicht (2) und/oder die Rückelektrodenschicht (4) bei einer Lichtwellenlänge von 700 nm eine Lichtabsorption von weniger als 5 % und bei einer Lichtwellenlänge von 950 nm von weniger als 8 % besitzt.

8. Dünnschichtsolarmodul nach Anspruch 1, **dadurch gekennzeichnet, dass** die reflektierende Schicht (5) aus einem weißen Material besteht.

9. Dünnschichtsolarmodul nach Anspruch 1, **dadurch gekennzeichnet, dass** die Frontelektrodenschicht (2) eine mittlere Schichtdicke von mindestens 400 nm und die Rückelektrodenschicht (4) eine mittlere Schichtdicke von mindestens 300 nm besitzt.

10. Dünnschichtsolarmodul nach einem der vorstehenden Ansprüche, **dadurch gekennzeichnet, dass** die Halbleiterschicht (3) aus Silizium besteht.

11. Verfahren zur Herstellung des Dünnschichtsolarmoduls nach Anspruch 1, **dadurch gekennzeichnet, dass** die dotierte Zinkoxid-Frontelektrodenschicht (2) und/oder die dotierte Zinkoxid-Rückelektrodenschicht (4) in einer Depositionsanlage (7) durch Sputtern abgeschieden wird.

12. Verfahren nach Anspruch 11, **dadurch gekennzeichnet, dass** in der
Depositionsanlage (7) zum Sputtern der Frontelektrodenschicht (2) und/oder der Rückelektrodenschicht (4) jeweils mehrere mit Aluminium- oder Galliumoxid als Fremdoxid versehene Zinkoxid-Sputtertargets (16, 17) vorgesehen sind, wobei in der Depositionsanlage (7) zum Sputtern der Frontelektrodenschicht (2) und/oder in der Depositionsanlage zum Sputtern der Rückelektrodenschicht (4) das Zinkoxid-Sputtertarget (16) in der dem Einschleusebereich (8) der Depositionsanlage (7) zugewandten Sputter-Station (13) ein höherer Fremdoxid-Gehalt aufweist als das Zinkoxid-Sputtertarget (17) in der dem Ausschleusebereich (14) zugewandten Sputter-Station (13).

13. Verfahren nach Anspruch 12, **dadurch gekennzeichnet, dass** das Zinkoxid-Sputtertarget (16) in der dem Einschleusebereich (8) zugewandten Sputterstation (12) der Depositionsanlage (7) zum Sputtern der Frontelektrodenschicht (2) und/oder der Rückelektrodenschicht (4) einen Fremdoxid-Gehalt zwischen 0,9 und 3,1 Gew.-% und das Zinkoxid-Sputtertarget (17) in der dem Ausschleusebereich (14) zugewandten Sputterstation (13) der Depositionsanlage (7) zum Sputtern der Frontelektrodenschicht (2) und/oder der Rückelektrodenschicht (4) einen Fremdoxid-Gehalt zwischen 0,2 und 1,5 Gew.-% aufweist.

14. Verfahren nach Anspruch 12 oder 13, **dadurch gekennzeichnet, dass** die Temperatur des Substrats (1) beim Sputtern der dotierten Zinkoxid-Frontelektrodenschicht (2) in der dem Einschleusebereich (8) zugewandten Sputterstation (12) von Raumtemperatur auf höchstens 280 °C in der dem Ausschleusebereich (14) benachbarten Sputterstation (13) ansteigt.

15. Verfahren nach Anspruch 12 oder 13, **dadurch gekennzeichnet, dass** die Temperatur des Substrats (1) beim Sputtern der dotierten Zinkoxid-Frontelektrodenschicht (2) in der dem Einschleusebereich (8) zugewandten Sputterstation (12) von 80 °C auf höchstens 250 °C in der dem Ausschleusebereich (14) benachbarten Sputterstation (13) ansteigt.

16. Verfahren nach Anspruch 12 oder 13, **dadurch gekennzeichnet, dass** die Temperatur des Moduls beim Sputtern der dotierten Zinkoxid-Rückelektrodenschicht (4) höchstens 240 °C beträgt.

17. Verfahren nach Anspruch 11 zur Herstellung des Dünnschichtsolarmoduls nach Anspruch 4 oder 5, **dadurch gekennzeichnet, dass** die dotierte Zinkoxid-Frontelektrodenschicht (2) an der von dem Substrat (1) abgewandten Seite vor dem Abscheiden der Halbleiterschicht (3) geätzt wird.

18. Verfahren nach Anspruch 11, **dadurch gekennzeichnet, dass** die dotierte Zinkoxid-Frontelektrodenschicht (2) und/oder die dotierte Zinkoxid-Rückelektrodenschicht (4) in einer Depositionsanlage (7) durch Sputtern abgeschieden wird, wobei mehrere oder alle Zinkoxid-Elektroden-Teilschichten in den Sputterstationen (12, 13) mit dem jeweils identischen Sputtergas oder Sputtergas-Gemisch deponiert werden.
